# EUROPEAN PATENT SPECIFICATION

(11) **EP 0 613 606 B1**
(45) Date of publication and mention of the grant of the patent: **10.07.2002**
(21) Application number: 93900667.2
(22) Date of filing: 19.11.1992
(51) Int. Cl.: H04Q 1/00, H04N 5/44

(54) **REMOTE CONTROL UNIT FOR COMMUNICATING PROGRAM DATA SIGNALS**
FERNSTEUERUNGSVORRICHTUNG ZUR KOMMUNIKATION VON PROGRAMMDATENSIGNALEN
UNITE DE COMMANDE A DISTANCE POUR COMMUNIQUER DES SIGNAUX DE DONNEES DE PROGRAMME

(30) Priority: 19.11.1991 US 795888
(43) Date of publication of application: 07.09.1994
(73) Proprietor: Scientific-Atlanta, Inc., Lawrenceville, GA 30044 (US)
(72) Inventor: COOK, Alex, M., Jr., Lawrenceville, GA 30244 (US); ROVIRA, Luis, A., Atlanta, GA 30341 (US); WALL, William, E., Jr., Atlanta, GA 30324 (US); JOHNSON, Lee, R., Lawrenceville, GA 30244 (US); MONTREUIL, Leo, Atlanta, GA 30341 (US); TING, Jeffrey, C., Lawrenceville, GA 30244 (US); KUBAN, Curt, M., Snellville, GA 30278 (US); MCGINTY, Emory, L., Lilburn, GA 30247 (US); LEVITAN, David, E., Dunwoody, GA 30338 (US); SHYU, Ruengung, Archie, Lawrenceville, GA 30244 (US)
(74) Representative: Kügele, Bernhard
(86) International application number: US9210192
(87) International publication number: WO9310642

(56) References cited:
- EP-A- 0 314 177
- WO-A-86/04476
- WO-A-89/03085
- GB-A- 2 188 458
- GB-A- 2 210 526
- GB-A- 2 215 928
- US-A- 4 534 025
- US-A- 4 626 848
- US-A- 4 698 670
- US-A- 4 728 949
- US-A- 4 755 883
- US-A- 4 855 725
- US-A- 4 979 174
- US-A- 5 031 046
- US-A- 5 054 071
- US-A- 5 084 891
- PATENT ABSTRACTS OF JAPAN vol. 9, no. 19 (E-292) (1742) 25 January 1985 & JP-A-59 167 143 (NIPPON DENKI K.K)

## Description

### Technical Field

The present invention generally relates to remote control systems and, more particularly, to a hand held remote control unit for communicating with a first controlled device by using a first communications protocol and controlling either a first controlled device or a second controlled device by using a selected second communications protocol and, furthermore, that displays program information associated with a program for the convenience of listeners/viewers as they are listening/viewing the program.

### Background Art

Presently, program content information, for example, song title, artist, record label, etc., is communicated to the customer/listener by announcers or disc jockeys (DJs) for audio programs transmitted by broadcast stations. In the case of video programs transmitted by broadcast means, video text messages are presented between programs and during interruptions of programs. In the case of many premium services, it is undesirable to interrupt programs for presentation of program content information. It may also be undesirable to have any form of announcer or DJ between programs or selections of music.

The cable television (CATV) industry is currently introducing audio-only services. Program content information is printed in a separate listing. These cable "radio stations" may play a continuous succession of musical selections without commercial interruptions. These services may not use a "disc-jockey" to identify the musical or other selections.

The announcements or interruptions of a program may be undesirable in some services. Nevertheless, it is highly desirable to communicate program content information. Frustration of customers, and possible loss of revenue due to subscription cancellation can occur if a subscriber has no method of knowing the title, composer, or artist of the particular selection of music. Currently, a subscriber viewing a premium video program must consult a separate listing, tune to a different channel, or wait till the end of the program for its identification. To the music industry, identification of the recording label and the musical selection is critical to the sale of recordings. To lovers of music, having such information as music tide, composer, artist and record label is vital. Without this information, the service will be reduced to the level of generic background music.

The prior art has recognized the requirement to communicate program content information associated with a broadcast performance. It is known to use a display to communicate program information associated with a performance to a listener and thereby, in essence, provide the function of a DJ for the convenience of the listener. Such a visual display could be built into the receiver itself, as described by the prior art, or it could be a separate display unit that would connect to an interface port of the receiver. The problem with such displays is that, unless they are very large and therefore costly, they cannot be easily placed within reading distance of the listener. Long cables for the display would be difficult to route in a typical living room, and one need only look at the lack of success of video cassette recorder (VCR) wired remote controls to convince oneself that such a tethered display would not be optimum.

In contrast, wireless remote controls have brought great convenience to the control of consumer products. Highly intelligent remote controls with liquid crystal displays (LCD) are available. Programmable and universal "learning" remote controls are available that emulate the functions of multiple other controls. A universal "learning" remote control typically receives control code information from another remote control unit during a learning mode and displays information, including available control functions, to the user.

Nevertheless, many typical wireless remote control systems, do not include a separate receiver to receive information from the device under control because such control systems only transmit a coded control signal at a relatively slow data rate of 50-100 baud. In general, such prior art systems do not provide for a two-way communications link between the remote control and the controllable device, nor do many remote controls receive and display any information obtained from the device under control. In addition, many remote control systems do not utilize an error detection system for the detection of an inaccurate transmission because such systems transmit the control signal at a relatively slow data rate, thereby eliminating any requirement for an error detection system.

Consequently, a requirement exists for a remote control system that communicates with the device under control by providing a hand-held electronic DJ display for receiving a program information signal at a rapid data rate and for displaying such program information associated with a program selection for the convenience of a listener and, furthermore, which is capable of controlling a group of controllable devices. Such a remote control would require a higher data rate for communications than the typical universal remote control because of the increased quantity of data, specifically program information data, provided to the remote control by the controllable device. In view of the increased quantity of data suggested by the communication of program information, an error detection scheme is also necessary to insure the accuracy of the data received by the remote control. Furthermore, to avoid the requirement for multiple remote control systems associated with a set of controllable consumer systems, a listener would benefit from the convenience provided by a wireless remote control system that includes a display for program information and, furthermore, operates to control multiple controllable devices.

Reference is also made to GB 2188458 (relative to which the invention is characterised), which describes a remote control system with key function display provisions. The transmitter unit of the system includes a key function display unit for identifying the functions of key elements of the transmitter unit of various steps of a control sequence for one or more controlled devices. The memory for storing character-representative information for identifying the functions of the key elements of the transmitter and corresponding function control instructions is contained in the controlled devices, and appropriate key function messages are sent back to the transmitter unit for reception and display. This is said to allow for the addition of new controlled devices without modification of the transmitter units.

Further reference may be made to US 4,855,725 and US 4,728,949.

### Disclosure of Invention

Aspects of the present invention are defined in the claims.

With the invention, problems associated with transmitting and providing a display of program information associated with an entertainment service, as well as controlling a group of controllable devices, can be solved. The present invention can ensure that a listener/viewer can continue to enjoy the convenience offered by use of a hand-held remote control unit, while also benefiting from a remote display that communicates display information, such as program information, by combining a handheld display of program information with a remote control unit that communicates with and controls a first controlled device, such as a music tuner, and controls a second controlled device, such as a community antenna television (CATV) set-top converter. A system constructed in accordance with the present invention can receive a program information signal at a rapid data rate to provide the listener/viewer with a display of the information on the remote control's display within a short period of time and, furthermore, controls selected functions of the controlled devices by transmitting a coded control signal at the more conventional, relatively slow data rate.

Briefly described, one embodiment of the present invention includes a hand held remote control apparatus for communicating with and selectively controlling at least one remotely located device, such as a digital music tuner connected to the CATV cable. The remotely located device is operative to carry out a controllable function upon receipt of a command delivered by a control signal from the remote control apparatus. A receiver is responsive to a display information signal transmitted by the remote device. The display information signal is of a substantially higher data rate than the control signal to permit the rapid communication of display information to the remote control apparatus from the remote device. A display displays the display information signal in alphanumeric characters. A keypad receives an operator input corresponding to a selected command for delivery to the remote device and provides a command signal. A transmitter responsive to the command signal transmits a control signal corresponding to the selected command to the remote device.

A benefit of having the display located within the hand held remote control unit is that the cost of the display need not be included within the cost of the controlled device, for example, a separate display need not be provided on the music tuner. Indeed, the display can be a value-added, extra-cost feature for optional purchase by the user. It can thus be seen as a means of increasing revenue, or of making an entertainment service affordable to those not desiring the remote control feature.

In summary, an advantage of an embodiment of the present invention is that it can provide an improved remote control system that communicates with a first device by use of a first communications protocol and controls the first device or a selected one of a group of second controlled devices by use of a separate second communications protocol.

Another advantage of an embodiment of the present invention is that it can also provide an improved two-way communications link between a remote control unit and a controllable device.

A further advantage of an embodiment the present invention is that it can provide an improved remote control unit having a display to communicate information received from a controllable device, in response to the remote control unit transmitting an information request to the controllable device.

A further advantage of an embodiment of the present invention is that it can effect a rapid transfer of program information between a controllable device and a remote control unit having a display.

A further advantage of an embodiment of the present invention is that it can effect an error-free communication of program information between a controllable device and a remote control unit.

### Brief Description of the Drawings

These and other advantages of the present invention may be appreciated from studying the following detailed description together with the drawings in which:
FIG. 1 is a overall block diagram of a system in which the preferred embodiment of the present invention is operative.
FIG. 2 is a detailed block diagram of the data signal receiver system utilized in the system shown in FIG. 1.
FIG. 3 is a block diagram of a synchronizing circuit utilized in the receiver shown in FIG. 2 to produce a infrared carrier signal used for transmitting a display information signal.
FIG. 4 is a diagram showing the waveforms produced by the synchronizing circuit of FIG. 3.
FIG. 5 is a top plan view of a remote control unit constructed in accordance with the preferred embodiment of the present invention.
FIG. 6 is a block diagram of the preferred remote control unit shown in FIG. 5.
FIG. 7 illustrates a typical second or control communications protocol associated with the control of a selected controllable device by the preferred remote control unit of FIG. 5.
FIG. 8 is a diagram illustrating the preferred control communications protocol associated with a control command signal transmitted by the preferred remote control unit of FIG. 5.
FIG. 9 is a diagram illustrating the preferred display information communications protocol associated with program information received and displayed by the preferred remote control unit of FIG. 5.
FIG. 10 is a flow chart diagram illustrating the error-checking method carried out by the preferred remote control unit of FIG. 5.

### Best Mode For Carrying Out The Invention

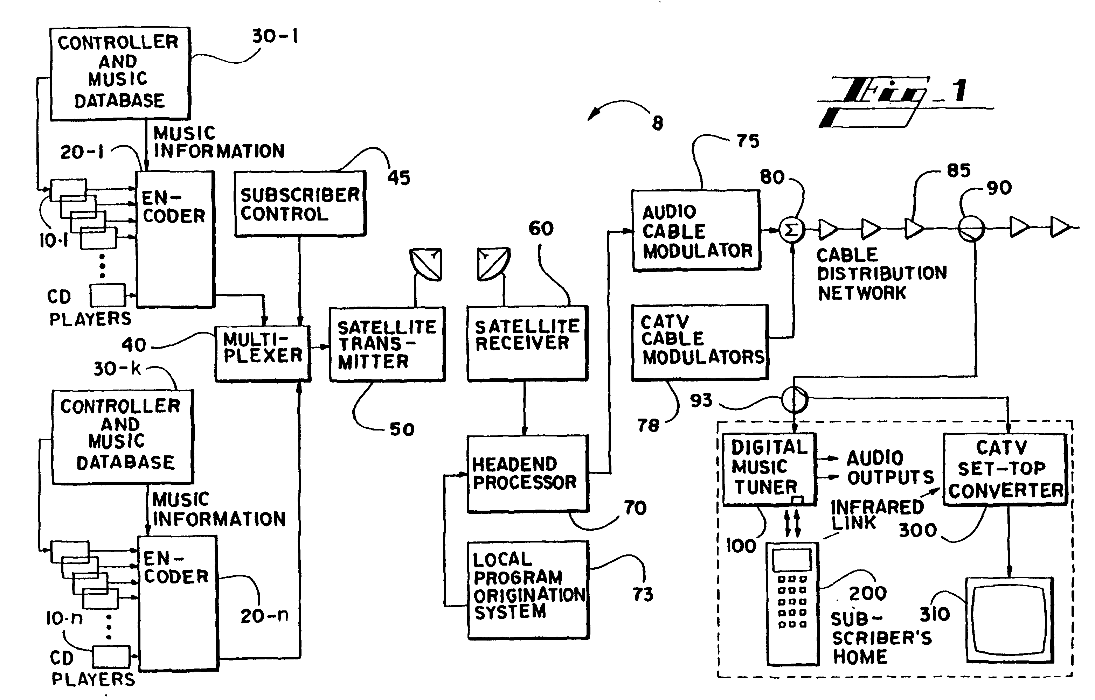

Referring to FIG. 1, a block diagram of an overall system **8** in which the preferred embodiment of the present invention is particularly suitable is illustrated. The present invention, preferably embodied in a remote control unit **200** that carries out the methods and functions described herein, will be described with respect to transmitting digital audio signals with program information. However, those skilled in the art will recognize that the present invention may, instead of transmitting audio with corresponding program information, transmit any of the following, with corresponding program information: television, games, software, video, and other combinations of audio/video or software information.

### Oyerall System

Compact disc (CD) players **10-1** through **10-n** provide a plurality of digital audio signals to the present invention. The CD players maybe the so called "jukebox" type wherein up to sixty or more compact discs may be stored and accessible by the player.

The digital audio signals from the CD players **10-1** through **10-n** are input to encoders **20-1** through **20-n.** The controller and music databases **30-1** through **30-k** controls each output of the CD players **10-1** through **10-n** and any respective selection of compact discs within these players. The controller and music databases **30-1** through **30-k** also provide a database containing program information with a one-to-one correspondence to the tracks contained on the compact discs. This program information includes title, track, artist, publisher, composers, song identification, and play time information blocks for each song contained on a compact disc.

These program information signals could also include other information relevant to describing the particular track contained on a compact disc, as those skilled in the art can appreciate. For example, if the information were historical audio data, information on the time and place such data was first conceived or transmitted also may be contained within this program information. Additionally, if the digital signals transmitted contained video information, the corresponding program information signals would relate to the video program being transmitted, for example, the title, actors, director, publisher, year, or other relevant information.

The plurality of digital audio signals inputted by the CD players **10-1** through **10-n** are combined in the encoders **20-1** through **20-n** with the program information signals inputted by the controller and music databases **30-1** through **30-k**. The combined signals from the encoders **20-1** through **20-n** are then inputted into a multiplexer **40** which combines the signals into a serial digital data stream.

Additional signals may be combined with the digital audio and program information signals. A subscriber control **45** contains information on various subscribers who may receive the digital audio data produced by the present invention. This subscriber information stored in the subscriber control **45** is multiplexed with the digital audio and program information signals in the multiplexer **40,** producing a serial digital data stream containing digital audio, program information, and national subscriber information.

The serial digital audio/program information stream from the multiplexer **40** is input into a satellite transmitter **50** and broadcast, via satellite, to a satellite receiver **60.** However, those skilled in the art will realize that any delivery system, not just satellite transmission, may be used, such as cable television, microwave distribution (MDS or MMDS), telephone systems, terrestrial broadcasts, and other coaxial or optical cable lines.

The satellite receiver **60** transfers the data to a headend processor **70**, which in turn converts and sends the information to audio cable modulator **75**, preferably a digital audio cable modulator. A local program origination system **73** also provides local program data, such as audio data originating from a local radio station, to the headend processor **70** for processing and conversion of the local program data prior to sending the local program data via a digital audio cable modulator **75** to a cable distribution system. CATV cable modulators **78** preferably accept video data from the headend processor **70** and modulates the video data for transmission over the cable distribution system. The digital audio data is then added with the video data from the CATV cable modulators **78** in a summing circuit **80** and a combined signal is sent over the cable distribution system.

Although analog video data is typically utilized by a conventional CATV system, those persons skilled in the art will appreciate that digital video data could also be input to the CATV cable modulators **78** for subsequent distribution over the cable distribution system. Furthermore, the headend processor **70** could also provide a video program information signal associated with the video data to the CATV cable modulator **78** and thereby introduce the video program information to the cable distribution network.

The cable distribution system includes line amplifiers **85** for boosting the signal and compensating for any line loss. A system tap **93** directs the combined signal of the digital audio data and the video data via the direct path of a coupler **90** to a subscriber's premises and into a first device, otherwise referred to as a first controlled device, which is preferably a digital music tuner (DMT) **100.**

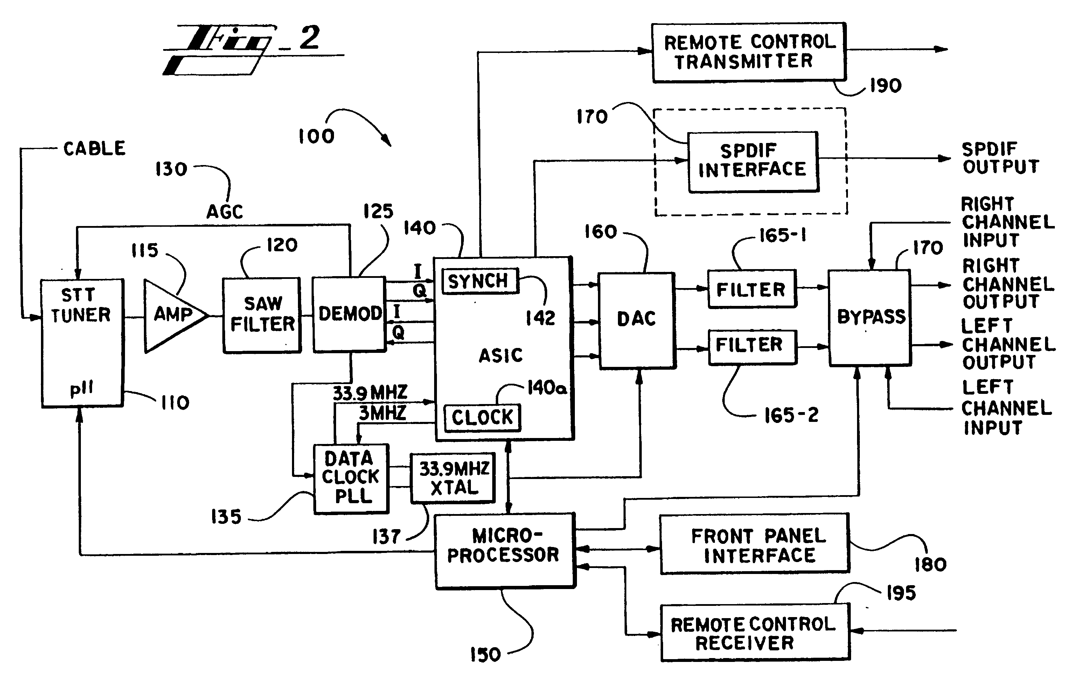

The digital music tuner **100**, more fully described with respect to FIGS. 2-4, selects a channel containing the digital audio and program information signals. Additionally, the digital music tuner **100** separates the digital audio signal from the program information signal. The digital audio signal is converted to an analog signal, amplified, and output on a subscriber's audio electronics, while the program information signal is processed and sent to an optional local display or a second device, preferably a remote control unit **200** having a display. The selected display then communicates to the subscriber the particular program information corresponding to an audio track currently being listened to by the subscriber.

The coupler **93** further directs the combined signal of the digital audio data and the video data to a second controlled device, preferably a CATV set-top converter **300** located within the subscriber's premises. The CATV set-top converter **300** selects a channel of video data and processes the video data in a conventional manner appreciated by those persons skilled in the art to provide a processed video signal for viewing via a television receiver **310**. If the video data is accompanied by a video program information signal associated with the video signal, then a CATV set-top converter having a video program information processor would separate the video signal from the video program information signal, process the video program information signal, and send the video program information to the television receiver **310** or to the remote control unit **200** for communicating the video program information to the subscriber.

The remote control unit **200** also is capable of controlling selected operating functions of both the tuner **100** and the set-top converter **300.** At any one time, the remote control unit controls either the tuner **100** or a selected one of a group of set-top conveners, such as the set-top converter **300**, or other remotely controllable devices such as VCRs, television. receivers, and the like.

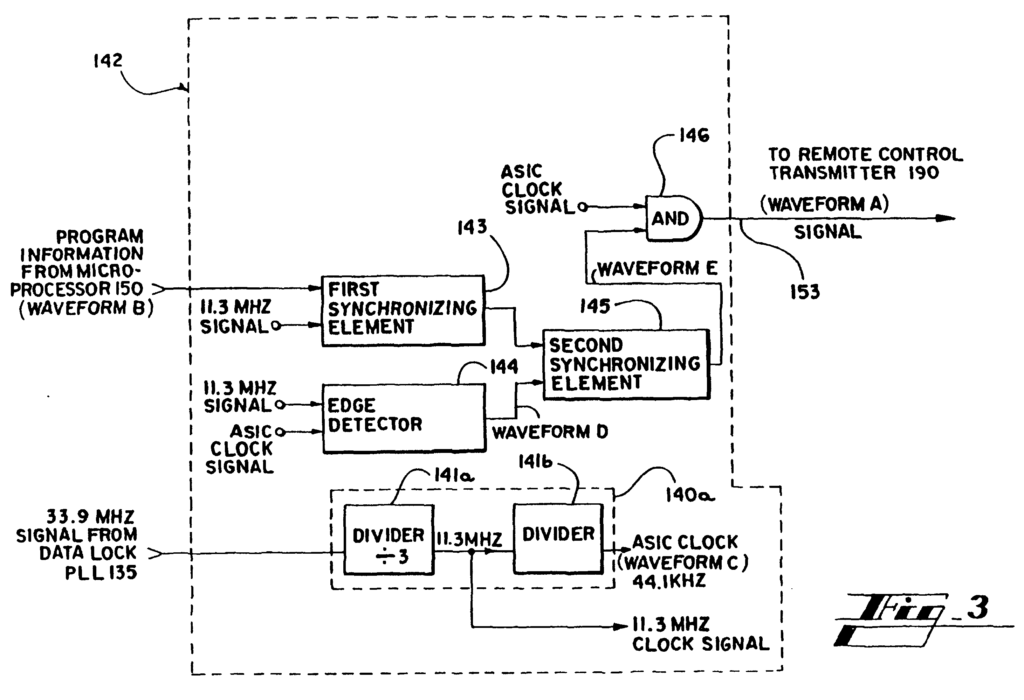

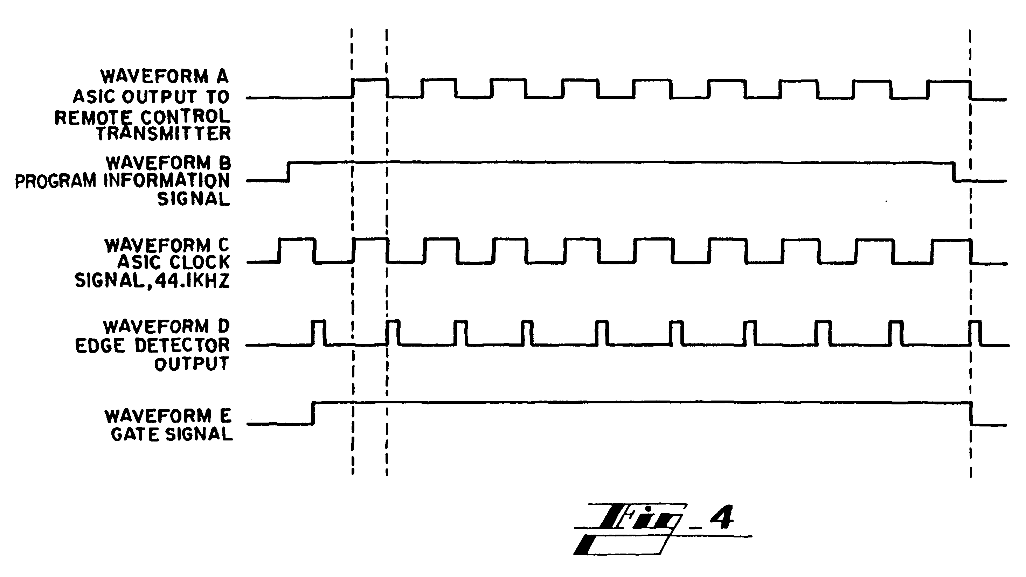

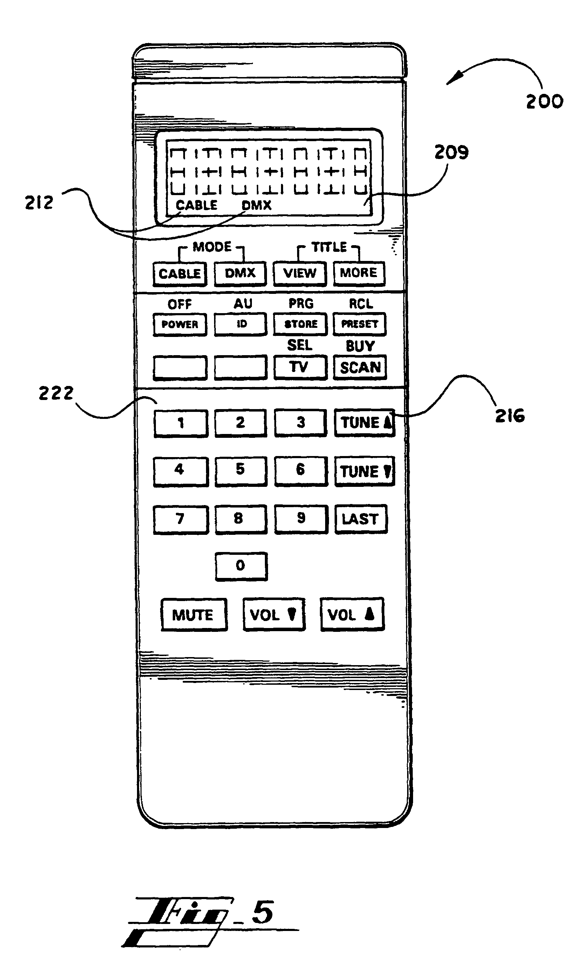

The preferred remote control unit **200** is more fully described with respect to FIGS. 5-7.

### Digital Music Tuner

FIG. 2 is a block diagram of the preferred digital music tuner **100**. Referring to FIGS. 1-2, the digital audio and program information signal is received by the head end processor **70** and passed, via the cable distribution system and the system tap **90**, into a set-top terminal tuner **110.** The terminal tuner **110** preferably includes phase-lock loop (PLL) circuitry. The signal from the terminal tuner **110** is amplified by an amplifier **115** and filtered by a saw filter **120** before being demodulated by a demodulator **125**. The terminal tuner **110** converts the selected radio frequency (RF) channel to a demodulation intermediate frequency (IF). The output of the demodulator **125** is quadrature partial response (QPR) demodulated to produce a 5.6 Mbps data stream containing five stereo pair of digital audio data to an applications specific integrated circuit (ASIC) **140.** The demodulator **125** also provides an automatic gain control signal **130** to the terminal tuner **110** to maintain constant signal level. Additionally, the demodulator **125** provides data to a data clock recovery PLL **135.** The data clock recovery PLL **135** contains a 33.8688 Megahertz (MHz) crystal **137** (about 33.9 MHz) for timing purposes.

The ASIC **140** provides demultiplexing, decrypting, and decoding operations upon the 5.6 Mbps data stream input by the demodulator **125.** The ASIC **140** separates the 5.6 Mbps data stream to a select one of five stereo pairs of digital audio signals. The selected stereo pair is decrypted and separated to provide a program information signal and a digital audio data signal. The digital audio data signal is then decoded utilizing a data compression technique described in United States Patent No. 4,922,537, incorporated herein by reference.

The ASIC **140** inputs the digital audio signals, provided at a sampling rate of 44.1 kHz, to a digital [to] analog converter (DAC) **160.** From the DAC **160,** analog left and right audio signals are filtered through filters **165-1** and **165-2** and input into a bypass **170.** The bypass **170** allows additional audio components (e.g., a CD player or tape deck) to be switchably connected with the digital music tuner **100.** A microprocessor **150** controls the PLL of the terminal tuner **110**, ASIC **140,** the DAC **160** and the bypass **170.**

The program information signal from the ASIC **140** is sent to the microprocessor **150** where it may be displayed on a front panel interface **180.** The ASIC **140** also sends the program information signal to a remote control transmitter **190** for transmission to the remote control unit **200.**

A remote control receiver **195,** coupled to the microprocessor **150,** receives instruction or control signals transmitted by the remote control unit **200** to initiate the remote control of selected functions of the tuner **100.** The remote control receiver **195** includes a demodulator and a photo diode. When the photo diode detects infrared energy, such as a command control signal from the remote control unit **200,** the photo diode outputs a detected infrared signal to the demodulator. The demodulator demodulates and filters the detected infrared signal and provides an output voltage signal to the microprocessor **150**.

Referring now to FIGS. 2-3, a clock signal generated internal to the ASIC **140** is utilized as a carrier signal to switch the output of the remote control transmitter **190** ON or OFF at a frequency of 44.1 kHz. It will be appreciated that because the 44.1 kHz sampling clock for audio digital to analog conversion in the DAC **160** happens to be within the common operative frequency range for infrared signal carriers (which vary from about 20 kHz to about 60 kHz), the 44.1 kHz clock from an ASIC CLOCK generator **140***a* may be utilized to generate a carrier signal for infrared signals sent by the remote control transmitter **190.** An ASIC CLOCK generator **140***a* therefore advantageously provides the clocking function for the DAC **160** (to convert the digital audio signals into analog audio signals), as well as the carrier signal function associated with signal transmissions by the remote control transmitter **190.** If the ASIC CLOCK generator **140***a* did not serve such dual signal functions, separate clock oscillators would otherwise be required to provide the clock signal and the carrier signal functions, thereby increasing the overall cost and complexity of the tuner **100**.

The ASIC clock generator **140***a* provides an ASIC CLOCK signal having a fixed first frequency to drive an interface **170**, which provides digital audio data at the fixed frequency. The ASIC CLOCK signal has a fixed frequency defined by the standard Sony-Phillips digital interface format (SPDIF), 44.1 kHz, because the digital audio signals previously have been sampled at such a defined frequency and, in addition, the interface **170** uses the standard SPDIF digital interface format.

The ASIC CLOCK signal provided by the ASIC clock **140***a* is derived from the about 33.9 MHz signal provided to the ASIC **140** by the data clock PLL **135**. Specifically, the ASIC CLOCK signal is derived by dividing the 33.9 MHz signal by three (3) to provide a second clock signal having a frequency of 11.3 MHz, and by then dividing the 11.3 MHz signal to the preferred fixed first frequency for the 44.1 kHz ASIC CLOCK signal. Dividers **141***a*, **141***b* provide these frequency dividing functions. The 11.3 MHz clock signal is utilized as a clock signal to drive selected operations conducted by the ASIC **140.**

FIG. 3 shows a synchronizing circuit **142** utilized within the ASIC **140** to provide clock synchronized program information signals to the remote control transmitter **190**. FIG. 4 shows the relationship between selected signals associated with the synchronizing circuit **142** in FIG. 3. In particular, the synchronizing circuit **142** operates to provide two separate timing alignment functions. First, the synchronizing circuit **142** aligns the program information signal provided by the microprocessor **150** to the 11.3 MHz clock signal. Second, the synchronizing circuit **142** aligns the 44.1 kHz ASIC CLOCK signal to the 11.3 MHz clock signal.

Referring to FIGS. 3-4, the synchronizing circuit **142** includes a first synchronizing element **143**, an edge detector **144**, a second synchronizing element **145**, and an AND gate **146**. The microprocessor **150** provides program information signals (waveform B) in the form of a serial data signal formatted in the appropriate display information protocol (described below) to the first synchronizing element **143.** The microprocessor **150** outputs the program information signals to the first synchronizing element **143** at a predefined data rate, preferably 4900 baud. In addition, the 11.3 MHz clock signal is provided as another input to the first synchronizing element **143.** The first synchronizing element **143** aligns the rising edge of the program information signals (waveform B) to the 11.3 MHz clock signal to provide an output signal synchronized with the 11.3 MHz clock.

The 11.3 MHz clock and the ASIC CLOCK signal of 44.1 kHz (waveform C) are input to an edge detector **144.** When the edge detector **144** detects a trailing edge of the ASIC clock signal (waveform C), it provides a narrow pulse that extends for one period of the 11.3 MHz clock signal (waveform D) to enable the operation of a second synchronizing element **145.** The second synchronizing element **145** accepts the synchronized output signal of the first synchronizing element **143** and produces a gate signal (waveform E) when the output signal of the edge detector **144** enables the second synchronizing element **145.**

The gate signal produced by the second synchronizing element **145** and the ASIC CLOCK signal of 44.1 kHz are provided as inputs to an AND gate **146.** When the gate signal represented by waveform E is high, the AND gate **146** outputs an integral number of periods (or cycles) of the ASIC CLOCK signal. Accordingly, the integral number of cycles of the ASIC CLOCK signal output (waveform A) by the AND gate **146** is effectively determined by the pulse width or pulse duration of the gate signal output by the second synchronizing element **145.**

The output of the ASIC **140** (waveform A), which is a carrier-modulated program information signal produced by an on/off keying technique, is provided from the synchronizing circuit **142** via line **153** to the remote control transmitter **190.** The transmitter **190** and the synchronizing circuit **142** comprise a pulse code modulator that transmits the program information signal by gating a signal source corresponding to the program information signal with a gate signal at the first frequency. It will also be appreciated that the pulse code modulator provides a pulse code modulated (PCM) signal having a predetermined bit rate, and that the gate signal is the 44.1 kHz clock signal.

For the preferred data rate of the program information signal, 4900 baud, a logic one level for the program information signal corresponds to nine cycles of the ASIC CLOCK signal. In other words, the fixed data rate for the program information signal is defined by a ratio of the first frequency associated with the ASIC CLOCK signal to a selected one of an integral number of cycles of the first frequency per bit. For example, when the first frequency is determined by the SPDIF standard, 44.1 kHz, and the integral number of cycles per bit is defined as 9, then the data rate is fixed at 4900 baud. In this manner, the remote control unit **200** efficiently receives the transmitted program information signal from the tuner **100** with a minimum amount of jitter in the received signal. An integral number of cycles per bit is preferred to ensure the accurate reception of the transmitted program information signal by the remote control unit **200.**

### Remote Control Unit

The remote control unit **200** operates to control selected functions of the tuner **100** and a selected second device, such as the CATV set-top convener **300**, a television receiver, a VCR, or the like, as well as to display the program information transmitted by the remote control transmitter **190** associated with the tuner **100.** A two-way wireless communications link exists between the tuner **100** and the remote control unit **200.** In contrast, a one-way wireless communications link exists between the remote control unit **200** and the set-top **300.**

Referring now to FIG. 5, the remote control unit **200,** preferably a hand-held unit, includes a top surface **222** having an alphanumeric character display **209** and a matrix of contact switches forming a keypad **216.** Each contact switch of the keypad **216** is covered by a push button or key that includes a label which defines the function or instruction initiated when the user presses the push button. In addition, selected areas of the top surface **222** of the remote control unit **200** include labels or other indicia that further designate the function or instruction associated with key.

FIG. 5 further illustrates certain operations conducted by the remote control unit **200,** readily identified by the indicia associated with certain of the keys of the keypad **216.** A user, who is a subscriber to both a digital music service and a cable television service, selects a control mode by pressing the CABLE button to initiate the control of a cable converter or, alternatively, by pressing the DMX button to initiate the control of the digital music tuner **100,** i.e. the digital music mode of operation. The control mode selected by the subscriber is preferably displayed by the display **209,** preferably with an annunciator such as the indicia **212,** CABLE or DMX.

Upon selecting the digital music mode of operation (DMX) by pressing the DMX button, the subscriber can control the functions of the tuner **100** in a manner similar to the use of currently popular wireless remote control units that control the functions of various consumer products, such as television receivers, VCRs, or CD players. Specifically, by pressing a selected key, the subscriber can initiate the transmission of a control command to the tuner **100** for either controlling a function of the tuner or requesting program information associated with a current program provided by the tuner. Each of the buttons or keys of the keypad **216** is labeled to indicate the function associated with the key. Those persons skilled in the art will appreciate that such control functions are similar to the control functions provided by other wireless remote controls for consumer products.

For example, the subscriber can review the program information associated with a current program by inputting an information request for transmission to the tuner **100.** By pressing the VIEW key, the subscriber initiates the transmission of an information request by the remote control unit **200** to the tuner **100.** The tuner **100** processes the information request and initiates a search for program information associated with the current program. If the program information is not found by the tuner **100** within a predetermined time period, typically about two seconds, the tuner **100** will respond to the transmitted information request by transmitting an error message to the remote control unit **200.**

Alternatively, if the search conducted by the tuner **100** discovers the program information, the tuner **100** will respond to the transmitted information request by transmitting the program information to the remote control unit **200** at a predetermined baud rate, preferably 4900 baud. The program information comprises the display information signal, described herein, and constitutes a program information message. A first or display information signal communications protocol associated with a transmission of the display information signals or program information messages by the tuner **100** is described in greater detail below. Upon reception of the program information message, the remote control unit **200** processes the received program information by checking the message for a transmission error. The error-checking scheme utilized by the remote control unit **200** will be described in greater detail below. After verifying that the message has been correctly received, the remote control unit **200** will direct the program information to the display **209** for communicating the message to the subscriber.

With respect to digital music signals, a typical program message includes information concerning the composer, the track title, the artist, and the album associated with the track title. Furthermore, the message may also include additional custom information concerning the current performance. The remote control unit **200** will also display operational messages indicating the progress of the processing of the information request, confirm the correct reception of the program information message, and provide an indication of errors if such errors occur during reception or processing.

During the CABLE mode of operation by the remote control unit **200**, which is enabled when the subscriber presses the CABLE button, the remote control unit **200** will operate to control a cable television converter, otherwise known as a set-top, selected from a group of set-tops. The subscriber programs the remote control unit **200** to operate with the subscriber's existing set-top (or other selectable remotely controllable device) during a cable set-up mode by pressing the CABLE and MORE buttons simultaneously for a time period greater than two seconds. In response to the subscriber's action, the display **209** will display a plurality of options for selection by the subscriber, for example, the option to select one of a plurality of set-top converters for remote control operations. If the subscriber has already selected a set-top option, the currently chosen set-top option will be displayed by the display **209.** Furthermore, additional options for set-tops or other remotely controllable devices that are operative for remote control by the remote control unit **200** are displayed for viewing by the subscriber when the subscriber presses the button MORE. In this manner, a menu of options will be provided to the subscriber to permit the subscriber to select a device for control by the remote control unit **200.**

When the display **209** displays an option that matches the subscriber's device, the subscriber can select the presently displayed option by pressing the CABLE button to enable the remote control unit **200** to control the selected device. The option selected by the subscriber in this manner will continue to remain programmed for control by the remote control unit **200** until a power reset occurs or until the time that the subscriber elects another option. After a power reset of the remote control **200**, the selected option will be cleared, thereby necessitating a new selection by the subscriber.

It should be understood that the preferred remote control unit **200** is pre-programmed to control a predetermined plurality of set-top converter units marketed by a variety of vendors within the CATV industry. In general, each vendor's set-top requires a unique second or control communications protocol for controlling the selected vendor's units. Consequently, the remote control unit **200** includes a preprogrammed read only memory (ROM) programmed to include a control communications protocol associated with the selected group of set-tops.

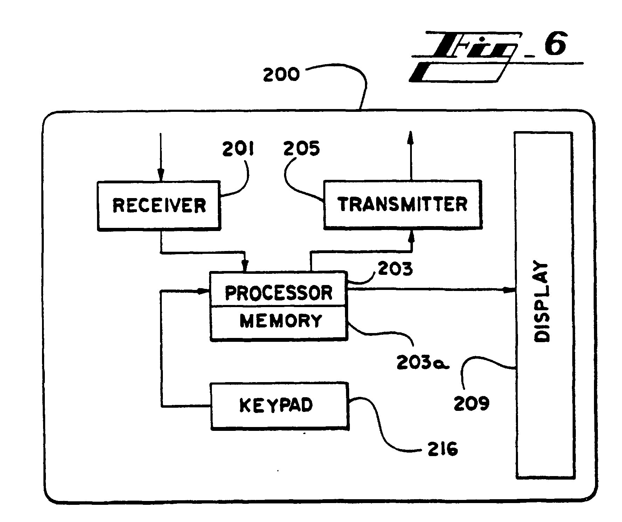

Referring now in this regard to FIG. 6, the preferred remote control unit **200** includes a processor **203,** preferably a microcomputer or microcontroller, having on-board mask programmed memory and a scratch pad memory, such as memory **203***a*. The preferred remote control unit **200** further includes a receiver **201,** a transmitter **205,** the keypad **216,** and the display **209.**

The memory **203***a* stores the incoming program information signal, the identification indicia associated with the selected controllable device, the set-top menu data, and operating software for the processor **203.** The memory **203***a* preferably includes both random access memory (RAM) and read only memory (ROM). For the preferred embodiment, the RAM is utilized to temporarily store the program information prior to communicating such data via the display **209,** as well as the identification indicia. In contrast, the ROM is utilized to store the operating software and a plurality of parameters associated with different communications protocols for the various groups of controllable devices. Those skilled in the art will appreciate that the memory **203***a* either could be internal or external to the processor **203.**

For example, the control signal protocols are stored in the memory **203***a*, preferably ROM. Thus, when the subscriber selects a set-top or other device for control, the subscriber also selects the proper control signal protocol to communicate with and control the selected device. The control protocol includes the properly formatted codes associated with control functions for the selected set-top or other device. When the subscriber selects a convener set-top (such as the Scientific Atlanta model 8600 set-top, one of the devices that is controllable by the preferred remote control unit **200**), certain keys on the keypad **216** may be utilized by a subscriber to initiate a control function suggested by the label attached to the selected key, as described above.

The remote control unit **200** operates to control selected functions of a first device, the digital music tuner **100**, as well as control selected functions of a selected controllable second device, preferably the CATV converter set-top **300** (FIG. 1), and to receive program information associated with a current program provided by the digital music turner **100.** Nevertheless, those persons skilled in the art will appreciate that the remote control unit **200** could also receive video program information from the CATV set-top converter **300** if the converter is capable of receiving, processing, and sending a video program information signal associated with the video data. The following description concerning the communication of program information associated with digital audio data between the tuner **100** and the remote control unit **200** is representative of a communication of video program information data between a video program information compatible set-top and the remote control unit **200.**

For a first operation mode, the keypad **216** receives control commands, such as program information commands associated with a request for program information or digital music tuner control commands associated with the control of the tuner **100,** from a subscriber, which are sent to the processor **203.** Those persons skilled in the art will recognize that each of the commands is input by a user to initiate the control of a selected function for the tuner **100** by the remote control unit **200.**

The processor **203** converts and sends a program information command or request and the digital music tuner control commands to the transmitter **205,** which subsequently transmits the appropriate control signals to the remote control receiver **195** associated with the tuner **100.** The received signal is input into the microprocessor **150** by the receiver **195,** where appropriate signals are sent therefrom to the ASIC **140** and the tuner **100** so as to bring about the subscriber's desired control function, such as the selection of an audio track, audio channel, or the transmission of program information.

Program information signals are received by the receiver **201** from the remote control transmitter **190** of the tuner **100.** The received signal is then input into the processor **203** which processes and sends the program information signal to the display **209** for communicating program information corresponding to the currently playing audio track to a user. The display **209** is preferably an LCD, although an LED, a braille reader, a voice synthesizer, or a cathode-ray tube or any other communicating device could also be utilized as may be appreciated by those skilled in the art. Audible or tactile communicating means would allow communication of the program information signals to users with disabilities, as would the use of the remote control unit.

Preferably, the two-way communications link between the digital music tuner **100** and the remote control unit **200** is an IR communications link. However, RF, ultrasonic, wire, fiber-optic cables, or other means could be used as those skilled in the art can appreciate. The concept could also be extended to carrying the information on the household power lines, telephone wires, coaxial cable, fiber-optic cable, or means other than the direct connection of a cable to the first controlled device.

For a second operation mode, the user may utilize the combination of the keypad **216** and the display **209** to select a set-top (or other controllable device) from a group of set-tops (or other controllable devices) and thereby enable the remote control unit **200** to control a second device, the selected set-top (or other controllable device). In this manner, the remote control unit **200** provides the flexibility of allowing the user to control an existing set-top if the existing set-top is included within the group of controllable set-tops. When the keypad **216** receives the appropriate control command from the user, the keypad **216** sends a selection command to the processor **203,** which, in turn, processes the selection command and sends set-top menu selection data to the display **209.**

In response to the set-top menu data, the display **209** displays a listing of the group of set-tops that are compatible for control by the remote control unit **200.** The user can subsequently select a controllable set-top from the group identified by the display **209** by using the keypad **216** to input a set-top selection signal. The processor **203** accepts the set-top selection signal from the keypad **216** and enables the remote control unit **200** to control the selected set-top. The group of set-tops are preferably representative of the popular converter set-tops marketed by various vendors and available for present use by user.

Once a particular set-top convener (or other controllable device) is selected for operation, the preferred processor **203** is further operative for storing identification indicia in a memory, such as a scratchpad memory associated with the preferred microcomputer, corresponding to selection of the selected controllable device from the plurality of controllable devices. The remote control unit **200** is thereafter operative to retrieve protocol parameters corresponding to the identification indicia from the scratchpad memory, so that appropriate control protocol for the selected device is utilized for communications with the selected device.

During the second operation mode, the keypad **216** receives set-top commands associated with the control of a selected set-top converter from a subscriber, which are then sent to the processor **203**. The processor **203** converts and sends the set-top control command signal to the transmitter **205**, which subsequently transmits the set-top control command to the set-top converter **300** to initiate a particular commanded function.

Although the preferred embodiment operates to control a controllable set-top selected from a group of set-tops, the remote control unit **200** could also be programmed to enable a user to select and control another controllable device selected from a group of controllable devices, such as digital music tuners, VCRs, television receivers, and the like. Those skilled in the art will appreciate that the user could select a controllable device from a group of controllable devices in a manner similar to the selection of the controllable set-top heretofore described.

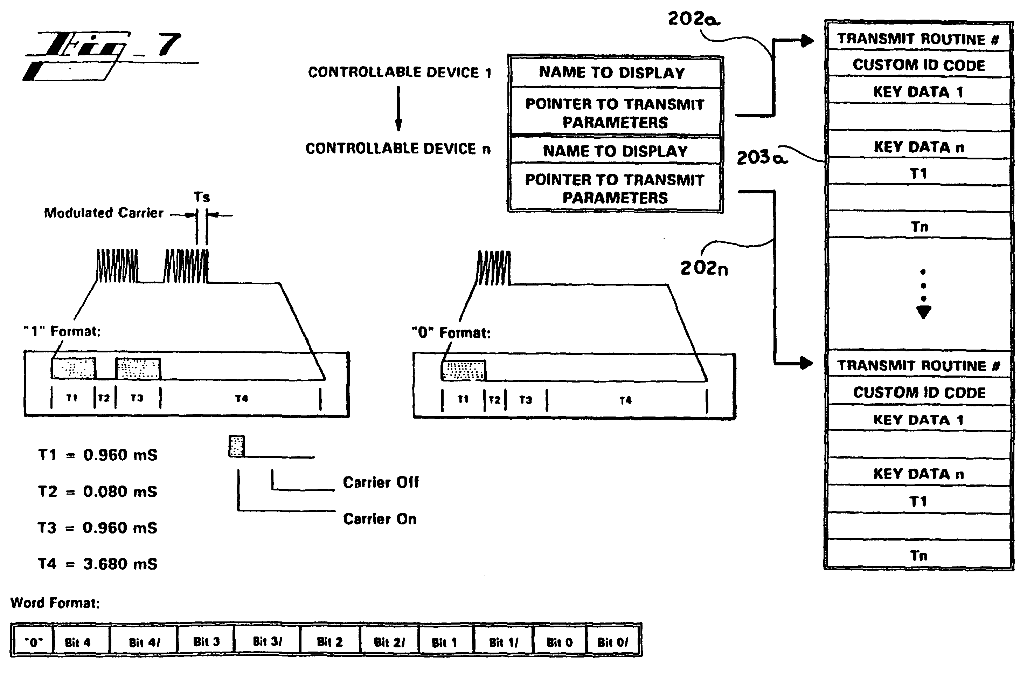

FIG. 7 depicts aspects of the selection of a second or control communications protocol associated with the control of a selected controllable device, such as a set-top selected from a group of controllable set-tops, or the control of the tuner **100.** The user can select a CATV set-top converter, such as the set-top **300,** from a group of controllable set-tops communicated by the display **209** during the operation of the remote control unit **200** in the converter set-up mode. By selecting a controllable set-top during the cable set-up mode state, the remote control unit **200** is enabled to control the selected functions of the selected set-top. Specifically, the user's set-top selection, which is displayed by the display **209,** is input via the keypad **216** to the processor **203** to initiate the selection of the appropriate second communications protocol associated with the selected set-top. The processor **203** retrieves from memory **203***a* appropriate protocol parameters associated with different control protocols corresponding to different controllable devices, and assembles a complete control message formatted in a selected control or second communications protocol for the selected device. The appropriately formatted control message is provided to the transmitter **205,** which transmits a control command signal within the second communications protocol associated with the selected set-top.

FIG. 7 illustrates that that memory **203***a* comprises a plurality of memory locations for storage of selected parameters of second communications protocols associated with the group of controllable devices that may be controlled by the use of the remote control unit **200**, including the tuner **100** and the converter set-top **300.** Likewise, the memory **203***a* stores selected parameters of the first communications protocol associated with the program information communicated by digital music tuner **100** and the second communications protocol associated with the control of certain functions of the tuner **100.** Although in the preferred embodiment, the user is not provided with an option to select a digital music tuner from a group of controllable digital music tuners, those skilled in the art will appreciate that the remote control unit **200** could be programmed to control one of a group of controllable digital music tuners and, therefore, the memory **203*a*** could include parameters of second communications protocols associated with a group of controllable digital music tuners.

It should be understood at this juncture that communication protocols (such as control protocols) typically have several layers, each of which may be considered a "protocol" in and of itself. For example, and shown in FIG. 7, various different remote control devices utilize different device level or transmission level protocols for defining a logical "1" and a logical "0" generated by a transmitting device. By example and not by way of limitation, a typical logical "1" comprises a period T1 of modulated carrier, a period T2 of no carrier, a period T3 of modulated carrier, and a period T4 of no carrier. A typical logical "0" comprises a period T1 of modulated carrier, a period T2 of no carrier, a period T3 of no carrier, and a period T4 of no carrier. Storage of the parameters T1, T2, T3, and T4, plus the period T5 of the modulated carrier, uniquely identify the protocol or bit format for "1" and "0".

In addition to such device level or transmission level protocols such as bit format protocols, there are protocol parameters associated with character definition or word definition, sometimes called character layer protocols. For example, characters or words typically comprise a predetermined number of bits, such as 7 or 8, sometimes with start and stop bits. As shown in FIG. 7, again by way of example and not by way of limitation, a typical word format or character format comprises eleven bits, with a "0" start bit, followed by five pair of data bits and complemented data bits, Bit 4, Bit 4/, Bit 3, Bit 3/, Bit 2, Bit 2/, Bit 1, Bit 1/, Bit 0, Bit 0/. Thus, a word format protocol may require storage in memory **203***a* of a parameter or parameters indicative that eleven bits of information are required to define a word or character, with the first bit being a "0" start bit.

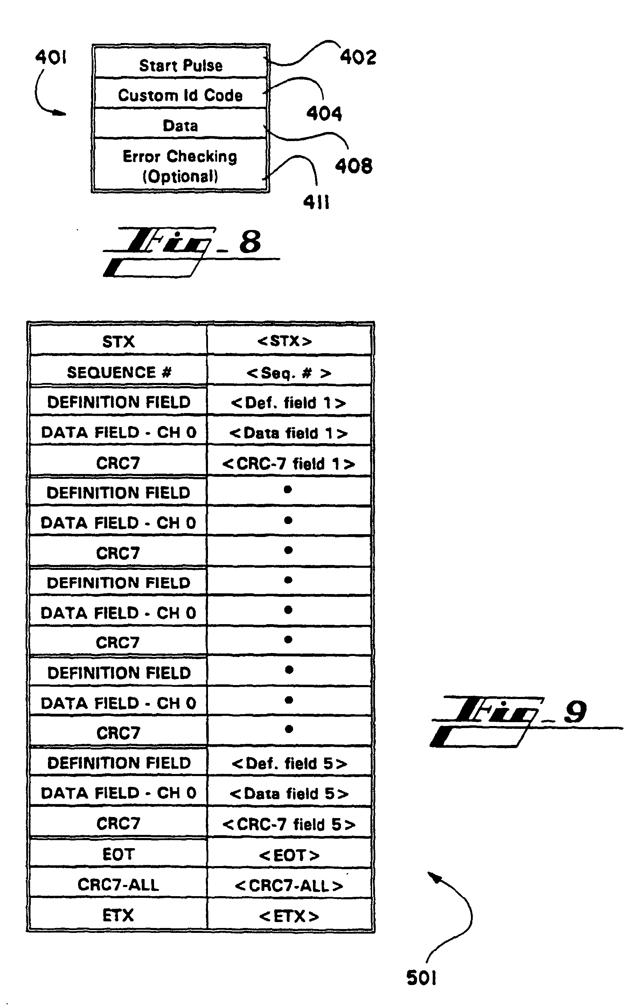

There are yet still further layers of protocols sometimes utilized in data communications. For example, a message layer protocol typically entails assembly of groups of characters into predetermined message portions. FIG. 8 below illustrates the assembly of characters provided with lower layer protocols to form a message or a control command.

FIG. 7 also shows exemplary storage of typical protocol parameters and selection of same for a selected device. For example, the remote control unit is operative to select one of controllable devices 1 through *n*.. During the cable set-top mode, the current set top selection is displayed on the display **209**. The current set top selection comprises the NAME TO DISPLAY shown in FIG. 7, which constitutes alphanumeric characters associated with the device.

Associated with the displayed NAME TO DISPLAY is a pointer **202*a*** (denominated **202***a* ... **202***n*) to memory locations, denominated POINTER TO TRANSMIT PARAMETERS. This pointer **202** is a software pointer to locations in the memory **203***a*. These memory locations store the protocol parameters required to communicate with a selected device, such as a TRANSMIT ROUTINE #, CUSTOM ID CODE, KEY DATA 1 ... KEY DATA n, and time parameters T1, T2, ... Tn. The TRANSMIT ROUTINE # comprise software routines for the processor **203** that enable the processor to implement a particular. or selected control protocol. The CUSTOM ID CODE is a predetermined code that identifies the remote control unit 200 as an authorized or operative remote controlling device. The KEY DATA n parameters relate particular digital codes to particular keys or switches associated with control functions for a selected controlled device. Finally, the timing parameters T1, T2, ... Tn correspond to the timing parameters described above for defining bit or word formats. Consequently, by selecting a particular set-top, a software pointer **202** utilized by the processor **203** selects the appropriate memory locations to retrieve the protocol parameters associated with the second communications protocol for the particular set-top. A similar pointer operation is conducted for the selection of the digital music tuner.

It will be understood that various infrared remote control devices for different set-top converters, VCRs, television sets, and the like manufactured by different vendors (i.e., second controlled devices) are controlled with different control protocols. It will be further understood that these "control protocols" or "control signals", as the terms are used herein, include various modulation schemes, keyboard encoding schemes, preamble data streams, keep alive pulse schemes, and other control information. It will therefore be understood that each of these control protocols include various parameters that define the protocol, including but not limited to carrier frequency (and period), bit codes defining preamble codes, bit codes defining key encoding schemes, numbers associated with the times a signal is repeated, and the like.

To implement the control protocol for a selected one of plurality of different controlled second devices, it is therefore necessary to store data in the remote control unit **200** corresponding to the particular parameters of the control protocol for each of the second devices that the remote control unit **200** is capable of controlling. The present invention is then operative, in the manner described herein, to enter a mode for selecting one of the plurality of second controlled devices, retrieve the appropriate and corresponding protocol parameters stored in ROM corresponding to the identification indicia stored in memory, and transmit an infrared control signal formatted in the selected control protocol for the selected controlled second device so as to cause the selected device to implement a command corresponding to a pressed key.

FIG. 8 illustrates the control communication data format or control protocol **401**, sometimes called a message layer protocol, utilized by the preferred remote control unit **200** in controlling the tuner **100**. However, it should be understood that the control protocol **401** is exemplary of second or control protocols often utilized in infrared remote control transmitters. It should be understood that the control protocol **401** is implemented by utilizing particular modulation schemes, and that both the modulation scheme and the data format shown in FIG. 8 are both considered "protocols," albeit at different levels. The control protocol **401** comprises four separate portions, including a start pulse **402,** a custom ID code portion **404,** a data portion **408,** and an (optional) error checking portion **411.** The first portion, a start pulse **402,** comprises one bit and is utilized to synchronize the operation of the remote control receiver **190.** The second portion, the custom ID code portion **404,** comprises six bits and is utilized to distinguish the control protocol associated with the tuner **100** from other control protocols. A third portion, the data portion **408,** comprises six bits of actual control data. The (optional) error checking portion **411** is used in some systems to provide a measure of error checking via cyclic redundancy check (CRC) codes or the like.

The data transmitted within the data portion **408** is provided to the tuner **100** by first transmitting the least significant bit of the data portion. To insure an accurate reception of a control command signal, each signal is transmitted twice by the remote control unit **200** in the preferred embodiment. The tuner **100** will not interpret two consecutive control command signals to be separate signals unless these control command signals are separated by a time interval of at least 250 milliseconds. Furthermore, all control command signals transmitted by the remote control unit **200** are preferably separated by a time interval of approximately 33 milliseconds of dead space before beginning another transmission. In this manner, the tuner **100** can distinguish separate control command signals from the pair. of repeated control command signals.

By now, it should be understood that the tuner **100** also utilizes a first or display information communications protocol to send a program information message to the remote control unit **200.** Each program information message consists of a maximum of 160 characters that, once received, can be displayed by the remote control unit **200** when the subscriber presses the VIEW key. The program information message comprises up to five message fields, wherein each message field includes two lines of 16 characters each, to provide a total of 32 displayable characters. Each character is defined by a character format that is similar to the format utilized for RS-232 serial interface, non-return-to-zero (NRZ) transmission.

The preferred character data format is defined by a series of ten bits that begins with a start bit, followed by eight data bits, and concludes with a stop bit. The start bit, defined as a logic 0, indicates the start of a character and the stop bit, defined as a logic HIGH, indicates the completion of a character and the conclusion of a character byte.

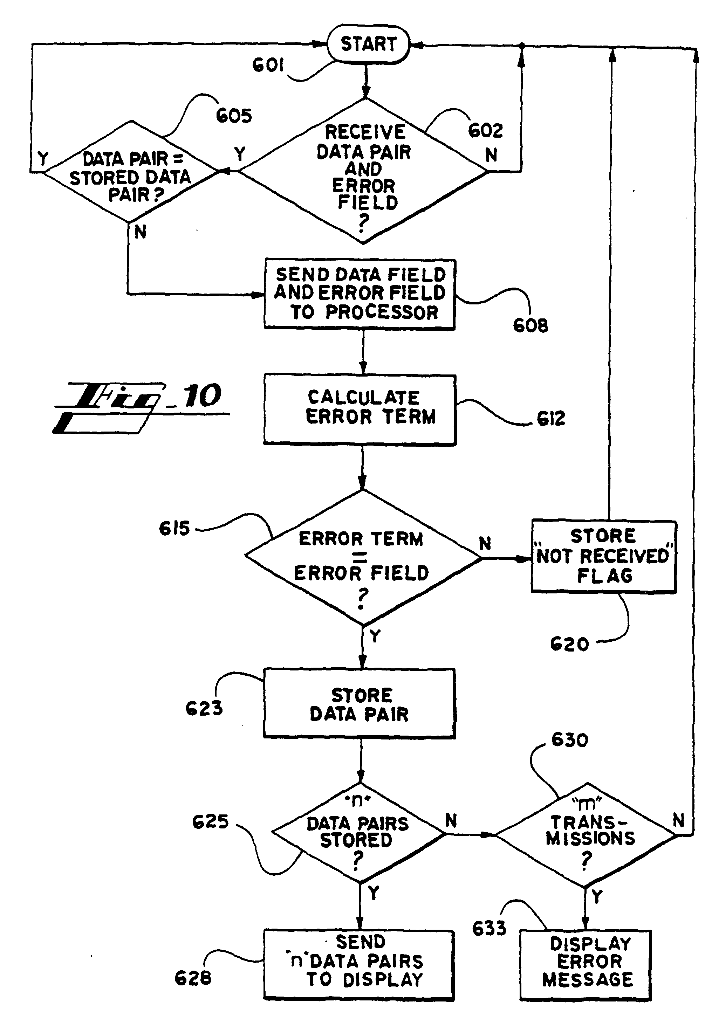

Refer now to FIG. 9 for a discussion of a table describing the first or display information communications protocol **501** for communicating a program information message between the tuner **100** and the remote control unit **200.** The protocol **501** is defined by a plurality of defined fields, comprising a start text or start of transmission field <STX>, a sequence # (number) field <Seq. #>, a group of definition fields <Def. Field n> interweaved with an associated group of data fields <Data Field n>, a group of error detection fields <CRC-7 Field n>, an end of text field <EOT>, a message error detection term <CRC-7 All>, and an end text or end of message field <ETX>.

FIG. 9 specifically illustrates the preferred protocol for the program information message utilized in the preferred embodiment, having a maximum message length of five data fields. The start text field, <STX> comprising one character, indicates the start of a program information message. Furthermore, the sequence number <Seq. #>, comprising one character, indicates the number of the present message within a repetition sequence (each message is sent four times, so that the sequence number field increments by one for each of the four transmissions).

Each data field <Data Field n> includes an associated definition field <Def. Field n>, which defines the class of information provided by the corresponding data field. Each definition field <Def. Field n> comprises one character. In contrast, each data field <Data Field n> comprises 32 characters.

It should be understood at this juncture that in the preferred embodiment, the definition fields comprise coded information signals and the data fields comprise uncoded information signals. The memory **203***a* stores a string of alphanumeric characters associated with each of a plurality of coded information signals. The processor **203** is responsive to the coded information signals or definition fields for retrieving selected alphanumeric characters from memory and for generating a corresponding alphanumeric display on the display **209.**

Stated in other words, the coded information signals correspond to a plurality of "headers" or predefined data categories to be displayed on the display **209.** For example, a single predetermined character code provided in the first definition field causes the display of the character string "TITLE" on the display, a single predetermined character code provided in the second definition field causes the display of the character string "TRACK", and a single predetermined character code provided in the third definition field causes the display of the character string "ARTIST". Moreover, the uncoded information signals correspond to particular items of data within one of the predefined data categories to be displayed on the display, for example, the particular title of the music being played, the particular track number, and the particular artist's name. The display **209** is operative to display predetermined alphanumeric characters corresponding to the coded information signals, prior to displaying alphanumeric characters corresponding to the uncoded information signals.

For a program information message including five data fields, a message further includes five definition fields, wherein each definition. field <Def. Field n> is associated with a corresponding data field <Data Field n> to define the category of the corresponding data field <Data Field n>. Each definition field <Def. Field n> represents a predefined data category that is stored in the memory **203***a***,** preferably the ROM. Prior to displaying a data field associated with a particular definition field, the display **209** displays the predefined data category to introduce the message information of the data field that will follow the particular definition field. The storage of such often-used data categories, such as title, track, artist, composer, or the like, each associated with a definition field <Def. field n> within the memory **203***a* of the remote control unit **200,** eliminates any requirement for the tuner 100 to transmit such information within a data field, thereby reducing the total length of a program information message and speeding up the transfer of the program information message.

Each error detection field <CRC-7 Field n> is associated with a corresponding pair of a definition field <Def. Field n> and its corresponding data field <Data Field n>. Each error detection field <CRC-7 Field n>, which comprises one character, provides an error calculation term for the associated pair of the definition field <Def. Field n> and its corresponding data field <Data Field n>. In this manner, the remote control unit **200** may verify the accuracy of the received program information message by comparing a calculated error detection term for a received pair comprising a definition field and a data field to the error detection field associated with the pair. The message error detection term <CRC-7 All>, comprising one character, enables the remote control unit **200** to verify the accuracy of the entire program, information message by comparing the message error detection to a calculated error detection term associated with the entire program information message.

The end of text field <EOT>, comprising one character, indicates the end of the textual data associated with the program information message. Also, the end of message field, <ETX>, comprising one character, indicates the conclusion of an entire program information message.

Furthermore, for the program information message including five data fields, the message further includes five error detection fields, wherein each of the error detection fields <CRC-7 Field n> is associated with a corresponding pair of a definition field <Def. Field n> and its corresponding data field <Data Field n>.

The tuner **100** transmits the same program information message for a predetermined number of times, preferably four times, before terminating the transmission to the remote control unit **200**. The opportunity for the remote control unit **200** to repeatedly receive the same program information message insures that the remote control unit **200** is more likely to accurately receive an entire, error free program information message prior to displaying the message for the convenience of the subscriber.

When the remote control unit **200** polls the tuner **100** by transmitting a control command signal requesting a program information message to the tuner **100**, the tuner **100** conducts a search for the beginning of the next program information message associated with the current program being provided via the cable. The search conducted by the tuner **100** is completed when the tuner **100** detects a start of transmission field <STX> within a predetermined time period. The tuner **100** then proceeds to repetitively send the same detected program information message to the remote control unit **200** during four separate intervals without first buffering or storing the complete program information message within a memory. Consequently, the maximum time interval necessary for the remote control unit **200** to receive a complete program information message is a first time interval defined by the four transmissions of the same program information message, and a second time interval defined by the tuner's search for the beginning of a complete message, i.e., the start of transmission field, <STX>, otherwise recognized as a latency period. In the preferred embodiment, the maximum time period for reception of a complete program information message by the remote control unit **200** is approximately 2 seconds.

If a program information message is not available at the tuner when the subscriber presses the VIEW key of the remote control unit **200,** the tuner **100** will transmit an error message for reception and display by the remote control unit **200.** Specifically, the tuner **100** will transmit three FFh (HEX) followed by four end-of-message fields to indicate the absence of the program information message at the tuner **100.** In addition, if the subscriber presses the VIEW key during the interval when the tuner **100** changes programs, the tuner **100** will transmit four end of message fields to terminate the communication between the tuner **100** and the remote control unit **200.**

FIG. 10 illustrates the method utilized by the preferred remote control unit **200** to verify the accuracy of the received program information message. This method is implemented as a program for the processor **203.**

To insure the rapid and accurate transmission and reception of the program information message, the first or display information protocol includes the group of error detection fields, wherein each error detection field is associated with a data pair comprising a definition field and its corresponding data field. Thus, starting at **601** in FIG. 10, the first inquiry at **602** is whether a definition field and its associated data field, and their associated error detection field have been received.

At step **605,** the inquiry is made whether the received data pair have already been stored as an error free data pair. If yes, the block **601** is returned to for receipt of the next data pair. If not, at step **608** the data pair and associated error detection field are sent to the processor for further processing.

At step **612,** the remote control unit **200** calculates an error detection term for each of the pairs of the definition fields and the corresponding data fields included within a received program information message. To verify the accuracy of the received program information message, at step **615** the remote control unit **200** compares the calculated error detection value to the error detection field included within the program information message for each of the definition field and the corresponding data field. If an error is detected, a "not received" flag is stored at **620,** indicative that the particular data pair has not been received and stored as error free.

If no error is detected at **615,** the data pair comprising the definition field and the data field are stored as an error free data pair at step **623.**

At step **625,** the processor determines whether all *n* of a plurality of data pair have been stored as error free. If so, all *n* data pair are sent to the display **209** for display at step **628.** It is at this point that the single character of the definition field of the data pair is replaced by the corresponding data string on the display, for example, "ARTIST" or "TITLE", while all characters of the data field of the data pair are displayed as is on the display **209.**

If at step **625** all *n* data pair have not been received, the program branches to **630,** where the inquiry has been made whether all *m* transmissions of the program information message have been sent. It will be recalled that in the preferred embodiment, there are at least four transmissions of each entire message, so *m* equals four. If all *m* transmissions have already been sent, the program branches to **633** and an error message, for example, "ERROR - PLEASE TRY AGAIN", "TRANSMISSION NOT RECEIVED", or the like, is displayed on the display **209.** If all *m* transmissions have not occurred, the program branches back to **601** and attempts to obtain the data pair on a subsequent transmission.

It will be understood that these steps are repeated for each of the fields associated with a selected program information message, and the message is accumulated within the memory **203***a*, preferably the RAM associated with the processor **203.** The processor **203** operates upon each accumulated pair of the definition field and the corresponding data field to calculate an error detection term associated with the accumulated pair. If the calculated error detection term matches the error detection term associated with the accumulated pair, the processor **203** identifies that accumulated field as an error-free field and stores the error-free field in the memory **203***a*. The error detection term is calculated by starting with the definition field and ending with the last byte of the corresponding data field. If the calculated error detection term does not match the term provided by the error detection field, the processor **203** repeats the error detection calculation process for the same pair provided by a subsequent transmission of the program information message because the tuner **100** repetitively transmits the message four separate times. The processor does not calculate an error detection term for any accumulated pair that has already been identified by the processor **203** as an error-free field.

This error detection calculation process is repeated until each pair of the definition field and the corresponding data field is identified as an error-free field or until the last transmission of the program information message is accumulated and processed by the remote control unit **200**. Consequently, if each of the five pairs of the definition field and the corresponding data field is identified as an error-free field after the first transmission of the program information message, the processor **203** ignores the subsequent transmission of the same program information message, retrieves each of the stored error-free fields, and initiates a display of the program information message.

Furthermore, the remote control unit **200** calculates an entire message error detection term based upon the entire program information message, beginning with the start text field and concluding with the end of text field, to verify the accuracy of the entire received program information message. The calculated entire message error detection term is compared to the entire message error detection field to validate the received program information message. Accordingly, the calculation of the entire message error detection term provide a redundant check for the accuracy of the received program information . message.

The remote control unit **200** preferably utilizes a cyclic redundancy check (CRC) for the error detection calculation associated with each of the pairs of the definition field and the corresponding data field and for the error detection calculation associated with the entire program information message. Those persons skilled in the art will recognize that other well known error detection calculations could be utilized to calculate an error detection term associated with the program information message.

From the foregoing description of the preferred embodiment, it will be appreciated that the present invention overcomes the disadvantages of the prior art and achieves the objects and advantages of the invention recited above. From the description, other embodiments will suggest themselves to those skilled in the art. Therefore, the scope of the present invention is to be limited only by the claims below.

## Claims

1. A hand held remote control apparatus (200) for communicating with and selectively controlling at least one remotely located device (100), said at least one remotely located device (100) being operative to carry out a controllable function upon receipt of a command delivered by a control signal from the hand held remote control apparatus, the hand held remote control apparatus comprising :
a receiver (201) responsive to a display information signal transmitted by said at least one remotely located device (100), said display information signal comprising an alphanumerical character information protocol;
a display (209) for displaying alphanumeric characters associated with said display information signal;
a keypad (216) for receiving an operator input corresponding to a selected command for delivery to said at least one remotely located device (100) and for providing a command signal; and
a transmitter (205) responsive to said command signal for transmitting a certain one of said control signals corresponding to said selected command to said at least one remotely located device; **CHARACTERISED IN THAT**:
the receiver (201) is operative to receive said display information signal at a higher data rate than the data rate at which said transmitter (205) transmits said control signal, to enable an operator to promptly view said alphanumeric characters via said display (209).

2. The hand held remote control apparatus of Claim 1, FURTHER **CHARACTERISED IN THAT** said at least one remotely located device (100) comprises a music tuner connected to a Community Antenna Television cable, and wherein said display information signal comprises a program information signal associated with music being provided on the CATV cable.

3. The hand held remote control apparatus of Claim 2, FURTHER **CHARACTERISED IN THAT** said program information signal includes title information, track information, and artist information associated with music being provided on the CATV cable.

4. The hand held remote control apparatus of Claim 1, FURTHER **CHARACTERISED BY** a controller (203) for receiving said display information signal from said receiver (201), generating display signals for said display (209), generating said command signal in response to actuation of an operator input on said keypad (216), and controlling said transmitter (205) to transmit said control signal.

5. The hand held remote control apparatus of Claim 4, FURTHER **CHARACTERISED IN THAT** said display information signal includes coded information signals and uncoded information signals, further comprising a memory (203(a)) for storing display signals associated with each of a plurality of said coded information signals, and wherein said controller (203) is responsive to said coded information signals for retrieving selected display signals from said memory (203(a)) and for generating corresponding display signals for said display (209).

6. The hand held remote control apparatus of Claim 5, FURTHER **CHARACTERISED IN THAT** said coded information signals correspond to a plurality of predefined data categories to be displayed on said display (209), and wherein said uncoded information signals correspond to particular items of data within one of said predefined data categories to be displayed on said display (209).

7. The hand held remote control apparatus of Claim 5, FURTHER **CHARACTERISED IN THAT** said display (209) is operative to display predetermined alphanumeric characters corresponding to said coded information signals, prior to displaying alphanumeric characters corresponding to said uncoded information signals.

8. The hand held remote control apparatus of Claim 1, FURTHER **CHARACTERISED IN THAT** said control signal comprises a predetermined remote control protocol signal for controlling said at least one remotely located device (100) and said display information signal comprises an alphanumeric character information protocol signal for transmitting error-free alphanumeric characters at a rate in excess of said remote control protocol signal.

9. The hand held remote control apparatus of Claim 8, FURTHER **CHARACTERISED IN THAT** said display information signal is about 4900 baud, and said remote control protocol signal is less than about 100 bits per second.

10. The hand held remote control apparatus of Claim 1, FURTHER **CHARACTERISED IN THAT** said hand held remote control apparatus is further operative to control one of a plurality of second remotely located devices (100, 300), each of said second remotely located devices (100, 300) being operative to carry out a controllable function upon receipt of said control signal from said hand held remote control apparatus.

11. The hand held remote control apparatus of Claim 10, FURTHER **CHARACTERISED IN THAT** said control signal comprises a predetermined remote control protocol signal for controlling one of said plurality of second remotely located devices (100, 300).

12. The hand held remote control apparatus of Claim 11, FURTHER **CHARACTERISED IN THAT** said second remotely located devices (100, 300) are infrared signal controlled and include a CATV cable-connected music tuner, a CATV cable- connected set top converter, a VCR, or a television receiver.

13. The hand held remote control apparatus of Claim 11, FURTHER **CHARACTERISED BY**:
a memory (203(a)) for storing a plurality of protocol parameters associated with different ones of said predetermined remote control protocol signal corresponding to different ones of said second remotely located devices (100, 300);
a controller (203), responsive to selection of a particular one of said second remotely located devices (100, 300) via said keypad (216), for selecting particular ones of said plurality of protocol parameters, said controller (203) further responsive to selected particular ones of said plurality of protocol parameters for providing a corresponding control signal to said transmitter (205).

14. The hand held remote control apparatus of Claim 1, FURTHER **CHARACTERISED IN THAT** said at least one remotely located device (100) comprises a music tuner connected to a Community Antenna Television cable, wherein said controllable function comprises the retrieval of program information being provided on said cable to said music tuner, and wherein said display information signal comprises alphanumeric information associated with said program information for display on said display (209).

15. The hand held remote control apparatus of Claim 1, FURTHER **CHARACTERISED IN THAT** said display (209) comprises a separate display on said hand held remote control apparatus for providing a display of information corresponding to said display information signals.

16. The hand held remote control apparatus of Claim 1, FURTHER **CHARACTERISED BY** a memory (203(a)) operative to store said received alphanumeric character information, and wherein said display (209) displays said alphanumeric character information stored in said memory (203(a)).

17. The hand held remote control apparatus of Claim 16, FURTHER **CHARACTERISED IN THAT** said display (209) displays said alphanumeric character information stored in said memory (203(a)) in response to said command signal.

18. The hand held remote control apparatus of Claim 1, FURTHER **CHARACTERISED BY** a timer (203) operative to sense whether the display information signal is received from the remotely located device (100) within a predetermined time period after said control signal is transmitted; and wherein said display (209) is responsive to said timer (203) to provide an indication when said display information signal is not received within said predetermined time period.

## Patentansprüche

1. Handgeführte Fernsteuerungsvorrichtung (200), um mit zumindest einer entfernt angeordneten Vorrichtung (100) in Kommunikation zu treten und diese selektiv zu steuern, wobei die benannte, zumindest eine entfernt angeordnete Vorrichtung (100) so funktioniert, dass nach Empfang eines Befehls, der durch ein Steuersignal von der handgeführten Fernsteuerungsvorrichtung geliefert worden ist, eine steuerbare Funktion ausgeführt wird, wobei die handgeführte Fernsteuerungsvorrichtung umfasst:
einen Empfänger (201), der auf ein Anzeigeinformationssignal anspricht, das von der benannten, zumindest einen entfernt angeordneten Vorrichtung (100) übermittelt wird, wobei das benannte Anzeigeninformationssignal ein alphanummerisches Zeicheninformationsprotokoll umfasst;
eine Anzeige (209) zur Anzeige von mit dem benannten Anzeigeninformationssignal verbundenen alphanummerischen Zeichen;
ein Tastenfeld (216) zur Aufnahme eines Betreibereingabesignals, das einem ausgewählten Befehl zur Auslieferung an die benannte, zumindest eine entfernt angeordnete Vorrichtung (100) entspricht, und zur Bereitstellung eines Befehlsignals;
einen Sender (205), der auf das benannte Befehlssignal anspricht, um ein bestimmtes der benannten Steuersignale, das dem benannten, ausgewählten Befehl entspricht, an die benannte, zumindest eine entfernt angeordnete Vorrichtung zu übermitteln; **DADURCH GEKENNZEICHNET, DASS**:
der Empfänger (201) so funktioniert, dass er das benannte Anzeigeninformationssignal mit einer höheren Datenübertragungsgeschwindigkeit als diejenige Datenübertragungsgeschwindigkeit empfängt, mit der der benannte Sender (205) das benannte Steuersignal übermittelt, um einen Betreiber in die Lage zu versetzen, die benannten alphanummerischen Zeichen unverzüglich über die benannte Anzeige (209) anzusehen.

2. Die handgeführte Fernsteuerungsvorrichtung des Anspruchs 1, WEITER **DADURCH GEKENNZEICHNET, DASS** die benannte, zumindest eine entfernt angeordnete Vorrichtung (100) ein Musikabstimmgerät umfasst, das an ein Gemeinschaftsantennen-Fernsehkabel angeschlossen ist, und worin das benannte Anzeigeninformationssignal ein Programminformationssignal umfasst, das der auf dem CATV-Kabel gelieferten Musik zugehörig ist.

3. Die handgeführte Fernsteuerungsvorrichtung des Anspruchs 2, WEITER **DADURCH GEKENNZEICHNET, DASS** das benannte Programminformationssignal Titelinformation, Spureninformation und Künstlerinformation enthält, die der auf dem CATV-Kabel gelieferten Musik zugehörig ist.

4. Die handgeführte Fernsteuerungsvorrichtung des Anspruchs 1, WEITER **GEKENNZEICHNET DURCH** ein Steuergerät (203) zum Empfang des benannten Anzeigeninformationssignals von dem benannten Empfänger (201), zur Erzeugung von Anzeigensignalen für die benannte Anzeige (209), zur Erzeugung des benannten Befehlssignals in Beantwortung der Betätigung einer Betreibereingabe auf dem benannten Tastenfeld (216) und zur Steuerung des benannten Senders (205), um das benannte Steuersignal zu übermitteln.

5. Die handgeführte Fernsteuerungsvorrichtung des Anspruchs 4, WEITER **DADURCH GEKENNZEICHNET, DASS** das benannte Anzeigeninformationssignal codierte Informationssignale und nicht codierte Informationssignale enthält, weiter einen Speicher (203(a)) umfassend, um Anzeigensignale zu speichern, die jedem einer Mehrzahl der benannten codierten Informationssignale zugehören, und worin das benannte Steuergerät (203) auf die benannten codierten Informationssignale anspricht, um ausgewählte Anzeigensignale aus dem benannten Speicher (203(a)) wiederzugewinnen und entsprechende Anzeigensignale für die benannte Anzeige (209) zu erzeugen.

6. Die handgeführte Fernsteuerungsvorrichtung des Anspruchs 5, WEITER **DADURCH GEKENNZEICHNET, DASS** die benannten codierten Informationssignale einer Mehrzahl von vordefinierten Datenkategorien entsprechen, die auf der benannten Anzeige (209) angezeigt werden sollen, und worin die benannten nicht codierten Informationssignale bestimmten Einzelheiten der Daten innerhalb einer der benannten vordefinierten Datenkategorien entsprechen, die auf der benannten Anzeige (209) angezeigt werden sollen.

7. Die handgeführte Fernsteuerungsvorrichtung des Anspruchs 5, WEITER **DADURCH GEKENNZEICHNET, DASS** die benannte Anzeige (209) so funktioniert, dass sie vorbestimmte alphanummerische Zeichen anzeigt, die den benannten codierten Informationssignalen entsprechen, ehe sie alphanummerische Zeichen anzeigt, die den benannten nicht codierten Informationssignalen entsprechen.

8. Die handgeführte Fernsteuerungsvorrichtung des Anspruchs 1, WEITER **DADURCH GEKENNZEICHNET, DASS** das benannte Steuersignal ein vorbestimmtes Fernsteuerungsprotokollsignal umfasst, um die benannte, zumindest eine entfernt angeordnete Vorrichtung (100) zu steuern, und das benannte Anzeigeninformationssignal ein alphanummerisches Zeicheninformationsprotokollsignal umfasst, um fehlerfreie alphanummerische Zeichen mit einer Geschwindigkeit zu übermitteln, die die des benannten Fernsteuerungsprotokollsignals übersteigt.

9. Die handgeführte Fernsteuerungsvorrichtung des Anspruchs 8, WEITER **DADURCH GEKENNZEICHNET, DASS** das benannte Anzeigeninformationssignal etwa 4900 Baud ist und dass das benannte Fernsteuerungsprotokollsignal weniger als etwa 100 Bits pro Sekunde ist.

10. Die handgeführte Fernsteuerungsvorrichtung des Anspruchs 1, WEITER **DADURCH GEKENNZEICHNET, DASS** die benannte, handgeführte Fernsteuerungsvorrichtung weiter so funktioniert, eine aus einer Mehrzahl von zweiten, entfernt angeordneten Vorrichtungen (100, 300) zu steuern, wobei jede der benannten zweiten, entfernt angeordneten Vorrichtungen (100, 300) so funktioniert, nach Empfang des benannten Steuersignals von der benannten, handgeführten Fernsteuerungsvorrichtung eine steuerbare Funktion auszuführen.

11. Die handgeführte Fernsteuerungsvorrichtung des Anspruchs 10, WEITER **DADURCH GEKENNZEICHNET, DASS** das benannte Steuersignal ein vorbestimmtes Fernsteuerungsprotokollsignal umfasst, um eine aus der benannten Mehrzahl von zweiten, entfernt angeordneten Vorrichtungen (100, 300) zu steuern.

12. Die handgeführte Fernsteuerungsvorrichtung des Anspruchs 11, WEITER **DADURCH GEKENNZEICHNET, DASS** die benannten zweiten, entfernt angeordneten Vorrichtungen (100, 300) infrarotsignalgesteuert sind und ein Musikabstimmgerät, das an ein CATV-Kabel angeschlossen ist, einen Set-Top-Umsetzer, der an ein CATV-Kabel angeschlossen ist, einen VCR oder einen Fernsehempfänger einschliessen.

13. Die handgeführte Fernsteuerungsvorrichtung des Anspruchs 11, WEITER **GEKENNZEICHNET DURCH**:
einen Speicher (203(a)) zur Speicherung einer Mehrzahl von Protokollparametern, die verschiedenen der benannten, vorbestimmten Fernsteuerungsprotokollsignale angehören, die verschiedenen der benannten zweiten, entfernt angeordneten Vorrichtungen (100, 300) entsprechen;
ein Steuergerät (203), das auf die Auswahl einer bestimmten von den benannten zweiten, entfernt angeordneten Vorrichtungen (100, 300) **durch** das benannte Tastenfeld (216) anspricht, um bestimmte aus der benannten Mehrzahl von Protokollparametern auszuwählen, wobei das benannte Steuergerät (203) weiter auf bestimmte ausgewählte aus der benannten Mehrzahl von Protokollparametern anspricht, um dem benannten Sender (205) ein entsprechendes Steuersignal zur Verfügung zu stellen.

14. Die handgeführte Fernsteuerungsvorrichtung des Anspruchs 1, WEITER **DADURCH GEKENNZEICHNET, DASS** die benannte, zumindest eine entfernt angeordnete Vorrichtung (100) ein Musikabstimmgerät umfasst, das an ein Gemeinschaftsantennten-Fernsehkabel angeschlossen ist, worin die benannte steuerbare Funktion die Wiedergewinnung von Programminformation umfasst, die dem benannten Musikabstimmgerät auf dem benannten Kabel zur Verfügung gestellt wird, und worin das benannte Anzeigeninformationssignal der benannten Programminformation zugehörige alphanummerische Information zur Anzeige auf der benannten Anzeige (209) umfasst.

15. Die handgeführte Fernsteuerungsvorrichtung des Anspruchs 1, WEITER **DADURCH GEKENNZEICHNET, DASS** die benannte Anzeige (209) eine getrennte Anzeige auf der benannten, handgeführten Fernsteuerungsvorrichtung umfasst, um eine Anzeige von Information zur Verfügung zu stellen, die den benannten Anzeigeninformationssignalen entspricht.

16. Die handgeführte Fernsteuerungsvorrichtung des Anspruchs 1, WEITER **GEKENNZEICHNET DURCH** einen Speicher (203(a)), der so funktioniert, dass er die benannte empfangene alphanummerische Zeicheninformation speichert, und worin die benannte Anzeige (209) die benannte, in dem benannten Speicher (203(a)) gespeicherte alphanummerische Zeicheninformation anzeigt.

17. Die handgeführte Fernsteuerungsvorrichtung des Anspruchs 16, WEITER **DADURCH GEKENNZEICHNET, DASS** die benannte Anzeige (209) die benannte, in dem benannten Speicher (203(a)) gespeicherte alphanummerische Zeicheninformation in Beantwortung des benannten Befehlssignals anzeigt.

18. Die handgeführte Fernsteuerungsvorrichtung des Anspruchs 1, WEITER **GEKENNZEICHNET DURCH** einen Zeitgeber (203), der so funktioniert, dass er fühlt, ob das Anzeigeinformationssignal von der entfernt angeordneten Vorrichtung (100) innerhalb einer vorbestimmten Zeit empfangen wird, nachdem das benannte Steuersignal übermittelt worden ist; und
worin die benannte Anzeige (209) auf den benannten Zeitgeber (203) anspricht, um eine Meldung zu liefern, wenn das benannte Anzeigeninformationssignal nicht innerhalb der benannten, vorbestimmten Zeit empfangen worden ist.

## Revendications

1. Dispositif de commande à distance portatif (200) destiné à communiquer avec au moins un dispositif situé de façon éloignée (100) et à commander de façon sélective celui-ci, ledit au moins un dispositif situé de façon éloignée (100) agissant pour exécuter une fonction pouvant être commandée lors de la réception d'une instruction délivrée par un signal de commande provenant du dispositif de commande à distance portatif, le dispositif de commande à distance portatif comprenant :
un récepteur (201) sensible à un signal d'informations d'affichage transmis par ledit au moins un dispositif situé de façon éloignée (100), ledit signal d'informations d'affichage comprenant un protocole d'informations de caractères alphanumériques,
un affichage (209) destiné à afficher des caractères alphanumériques associés audit signal d'informations d'affichage,
un pavé numérique (216) destiné à recevoir une saisie d'opérateur correspondant à une instruction sélectionnée en vue d'une délivrance audit au moins un dispositif situé de façon éloignée (100) et destiné à fournir un signal d'instruction, et
un émetteur (205) sensible audit signal d'instruction destiné à transmettre un certain signal parmi lesdits signaux de commande correspondant à ladite instruction sélectionnée vers ledit au moins un dispositif situé de façon éloignée, **CARACTERISE EN CE QUE** :
le récepteur (201) agit pour recevoir ledit signal d'informations d'affichage à un débit de données plus élevé que le débit de données auquel ledit émetteur (205) transmet ledit signal de commande, afin de permettre à un opérateur de visualiser rapidement lesdits caractères alphanumériques par l'intermédiaire dudit affichage (209).

2. Dispositif de commande à distance portatif selon la revendication 1, **CARACTERISE EN OUTRE EN CE QUE** ledit au moins un dispositif situé de façon éloignée (100) comprend un syntoniseur de musique relié à un câble de télévision par câble, et dans lequel ledit signal d'informations d'affichage comprend un signal d'informations de programme associé à la musique qui est fournie sur le câble de télévision CATV.

3. Dispositif de commande à distance portatif selon la revendication 2, **CARACTERISE EN OUTRE EN CE QUE** ledit signal d'informations de programme comprend des informations de titre, des informations de piste, et des informations d'artiste associées à la musique qui est fournie sur le câble de télévision CATV.

4. Dispositif de commande à distance portatif selon la revendication 1, **CARACTERISE EN OUTRE PAR** un contrôleur (203) destiné à recevoir ledit signal d'informations d'affichage provenant dudit récepteur (201), à générer des signaux d'informations pour ledit affichage (209), à générer ledit signal d'instruction en réponse à une opération de saisie d'un opérateur sur ledit pavé numérique (216), et à commander ledit émetteur (205) pour transmettre ledit signal de commande.

5. Dispositif de commande à distance portatif selon la revendication 4, **CARACTERISE EN OUTRE EN CE QUE** ledit signal d'informations d'affichage comprend des signaux d'informations codés et des signaux d'informations non codés, comprenant en outre une mémoire (203(a)) destinée à mémoriser des signaux d'informations associés à chacun d'une pluralité desdits signaux d'informations codés, et dans lequel ledit contrôleur (203) est sensible auxdits signaux d'informations codés en vue de récupérer des signaux d'informations sélectionnés à partir de ladite mémoire ((203(a)) et en vue de générer des signaux d'informations correspondants pour ledit affichage (209).

6. Dispositif de commande à distance portatif selon la revendication 5, **CARACTERISE EN OUTRE EN CE QUE** lesdits signaux d'informations codés correspondent à une pluralité de catégories de données prédéfinies devant être affichées sur ledit affichage (209), et dans lequel lesdits signaux d'informations non codés correspondent à des éléments particuliers de données à l'intérieur de l'une desdites catégories de données prédéfinies devant être affichées sur ledit affichage (209).

7. Dispositif de commande à distance portatif selon la revendication 5, **CARACTERISE EN OUTRE EN CE QUE** ledit affichage (209) agit pour afficher des caractères alphanumériques prédéterminés correspondant auxdits signaux d'informations codés, afin d'afficher des caractères alphanumériques correspondant auxdits signaux d'informations non codés.

8. Dispositif de commande à distance portatif selon la revendication 1, **CARACTERISE EN OUTRE EN CE QUE** ledit signal de commande comprend un signal de protocole de commande à distance prédéterminé destiné à commander ledit au moins un dispositif situé de façon éloignée (100) et ledit signal d'informations d'affichage comprend un signal de protocole d'informations de caractères alphanumériques destiné à transmettre des caractères alphanumériques exempts d'erreur à un débit dépassant celui dudit signal de protocole de commande à distance.

9. Dispositif de commande à distance portatif selon la revendication 8, **CARACTERISE EN OUTRE EN CE QUE** ledit signal d'informations d'affichage est d'environ 4 900 bauds, et ledit signal de protocole de commande à distance est inférieur à environ 100 bits par seconde.

10. Dispositif de commande à distance portatif selon la revendication 1, **CARACTERISE EN OUTRE EN CE QUE** ledit dispositif de commande à distance portatif agit en outre pour commander l'un d'une pluralité de seconds dispositifs situés de façon éloignée (100, 300), chacun desdits seconds dispositifs situés de façon éloignée (100, 300) agissant pour exécuter une fonction pouvant être commandée lors de la réception dudit signal de commande provenant dudit dispositif de commande à distance portatif.

11. Dispositif de commande à distance portatif selon la revendication 10, **CARACTERISE EN OUTRE EN CE QUE** ledit signal de commande comprend un signal de protocole de commande à distance prédéterminé destiné à commander l'un de ladite pluralité de seconds dispositifs situés de façon éloignée (100, 300).

12. Dispositif de commande à distance portatif selon la revendication 1, **CARACTERISE EN OUTRE EN CE QUE** lesdits seconds dispositifs situés de façon éloignée (100, 300) sont commandés par signaux infrarouges et comprennent un syntoniseur de musique relié par câble de télévision CATV, un décodeur relié par câble de télévision CATV, un magnétosocope (VCR), ou un récepteur de télévision.

13. Dispositif de commande à distance portatif selon la revendication 11, **CARACTERISE EN OUTRE PAR** :
une mémoire (203(a)) destinée à mémoriser une pluralité de paramètres de protocoles associés à différents signaux parmi lesdits signaux de protocoles de commande à distance prédéterminés correspondant à des dispositifs différents parmi lesdits seconds dispositifs situés de façon éloignée (100, 300),
un contrôleur (203), sensible à une sélection d'un dispositif particulier parmi lesdits seconds dispositifs situés de façon éloignée (100, 300) par l'intermédiaire dudit pavé numérique (216), destiné à sélectionner des paramètres particuliers parmi ladite pluralité de paramètres de protocoles, ledit contrôleur (203) étant en outre sensible à des paramètres particuliers sélectionnés parmi ladite pluralité de paramètres de protocoles en vue de fournir un signal de commande correspondant audit émetteur (205).

14. Dispositif de commande à distance portatif selon la revendication 1, **CARACTERISE EN OUTRE EN CE QUE** ledit au moins un dispositif situé de façon éloignée (100) comprend un syntoniseur de musique relié à un câble de télévision par câble, où ladite fonction pouvant être commandée comprend la récupération d'informations de programme qui sont fournies sur ledit câble audit syntoniseur de musique, et où ledit signal d'informations d'affichage comprend des informations alphanumériques associées auxdites informations de programme en vue d'un affichage sur ledit affichage (209).

15. Dispositif de commande à distance portatif selon la revendication 1, **CARACTERISE EN OUTRE EN CE QUE** ledit affichage (209) comprend un affichage séparé sur ledit dispositif de commande à distance portatif en vue de fournir un affichage d'informations correspondant auxdits signaux d'informations d'affichage.

16. Dispositif de commande à distance portatif selon la revendication 1, **CARACTERISE EN OUTRE PAR** une mémoire (203(a)) agissant pour mémoriser lesdites informations de caractères alphanumériques reçues, et dans lequel ledit affichage (209) affiche lesdites informations de caractères alphanumériques mémorisées dans ladite mémoire (203(a)).

17. Dispositif de commande à distance portatif selon la revendication 16, **CARACTERISE EN OUTRE EN CE QUE** ledit affichage (209) affiche lesdites informations de caractères alphanumériques mémorisées dans ladite mémoire (203(a)) en réponse audit signal d'instruction.

18. Dispositif de commande à distance portatif selon la revendication 1, **CARACTERISE EN OUTRE PAR** un temporisateur de cadencement (203) agissant pour détecter si le signal d'informations d'affichage est reçu depuis le dispositif situé de façon éloignée (100) dans un intervalle de temps prédéterminé après que ledit signal de commande soit transmis, et dans lequel ledit affichage (209) est sensible audit temporisateur de cadencement (203) afin de fournir une indication lorsque ledit signal d'informations d'affichage n'est pas reçu dans ledit intervalle de temps prédéterminé.
